(19) Europäisches Patentamt
European Patent Office
Office européen des brevets

(11) **EP 1 860 779 A1**

(12) **EUROPEAN PATENT APPLICATION**
published in accordance with Art. 158(3) EPC

(43) Date of publication:
**28.11.2007 Bulletin 2007/48**

(51) Int Cl.:
***H04B 1/10*** *(2006.01)*

(21) Application number: **06729062.7**

(22) Date of filing: **14.03.2006**

(86) International application number:
**PCT/JP2006/305028**

(87) International publication number:
**WO 2006/098323 (21.09.2006 Gazette 2006/38)**

(84) Designated Contracting States:
**DE NL**

(30) Priority: **17.03.2005 JP 2005077530**

(71) Applicant: **Pioneer Corporation**
**Tokyo 153-8654 (JP)**

(72) Inventors:
• **KANNO, Hideyuki,**
**Kawagoe Koujou, Pioneer Corporation**
**Saitama, 350-8555 (JP)**

• **OHASHI, Toru,**
**Kawagoe Koujou, Pioneer Corporation**
**Saitama, 350-8555 (JP)**

(74) Representative: **Bohnenberger, Johannes et al**
**Meissner, Bolte & Partner GbR,**
**Postfach 86 06 24**
**81633 München (DE)**

(54) **NOISE CANCELLER**

(57)     The present invention is to provide a noise canceller which, when removing a noise mixed in an input signal, can remove the noise without internally generating another noise component.

A noise period detecting unit 8 detects a noise mixing period τ of a noise in an input signal Sin, while a correction period setting unit 9 sets a period including the noise mixing period τ and an additional period Tadd as a correction period. During the correction period (τ+Tadd), a hold unit 6 holds the input signal Sin and outputs a hold signal SHA. A first mute unit 4 applies a mute processing to the input signal Sin to generate a correction signal SB and a second mute unit 7 applies a mute processing to the hold signal SHA to generate an interpolation signal SA. A first gain adjusting unit 10 adjusts the gains of the first and second mute means during at least the noise mixing period τ and the additional period Tadd of the correction period. A synthesizing unit 5 synthesizes together the correction signal SB and the correction signal SB generated by the foregoing adjustment, thereby removing a mixed noise and generating an output signal Sout having a waveform similar to the input signal Sin, without newly generating a high frequency noise component.

*FIG.2*

EP 1 860 779 A1

**Description**

Technical Field

The present invention relates to a noise canceller which removes a noise mixed in an input signal.

Background Technique

In the field of signal processing technique, it is important to remove an external noise mixed in an input signal which is to be processed.

For example, a broadcast receiver or the like mounted in an automobile is apt to be affected by an external noise such as an ignition noise or the like. In view of this, a processing such as a detection and a demodulation or the like is usually not immediately applied to an intermediate frequency signal (IF signal) obtained by mixing together a high frequency reception signal (RF reception signal) and a turning frequency local oscillation signal and by performing a frequency conversion thereon. Rather, a processing such as a detection and a demodulation or the like is usually carried out after an external noise mixed in the intermediate frequency signal has been removed using a noise canceller.

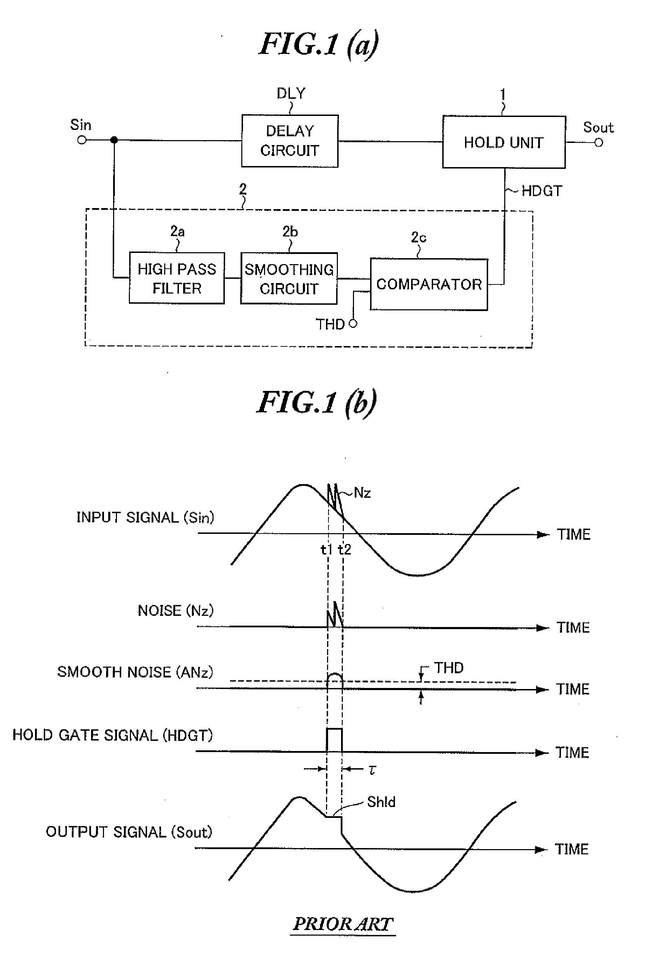

Fig. 1(a) is a block diagram showing the composition of a conventional noise canceller usually provided in a vehicle broadcast receiver, Fig. 1(b) is a timing chart showing the functions of the noise canceller. As shown, the conventional noise canceller comprises a hold unit 1, a hold control unit 2, and a delay circuit DLY.

The hold control unit 2 includes a high pass filter 2a which extracts a noise Nz currently mixed in an intermediate frequency signal (input signal) Sin, a smoothing circuit 2b which smoothes the extracted noise ANz to generate a smooth noise ANz, and a comparator 2c which compares the smooth noise ANz to a predetermined threshold value THD, thereby detecting, as a noise mixing period $\tau$, a period during which the level of the smooth noise ANz is larger than the threshold value THD, thus outputting a hold gate signal HDGT which is logical "H".

The delay circuit DLY is a delay device for adjusting a delay time generated in the hold control unit 2.

When the hold gate signal HDGT is logical "L", the hold unit 1 will allow the input signal Sin to pass therethrough without processing, and outputs the signal as an output signal Sout to a detector or the like. On the other hand, when the hold gate signal HDGT is logical "H", the hold action will be continued, while a hold signal component Shld is outputted as an output signal Sout to the detector or the like. Namely, at a time point t1 at which the hold gate signal HDGT is reversed from logic "L" to "H" (when a noise Nz has been detected), the hold unit 1 will hold the signal component of the input signal Sin. Meanwhile, when the hold gate signal HDGT is becoming logical "H", the hold unit 1 will output a hold signal component Shld having a constant level, and will terminate the hold action at a time point t2 at which the hold gate signal HDGT is again reversed from logic "H" to "L" (when the noise Nz has ended), thereby outputting the input signal Sin as an output signal Sout, thus removing the noise Nz during a noise mixing period T.

Description of the Invention

Problem(s) to be Solved by the Invention

However, the above-mentioned conventional noise canceller has been found to have the following problem. Namely, at a time point t2 at which the noise mixing period $\tau$ has ended, the output signal Sout of the hold unit 1 will be switched over from a hold signal component Shld to an input signal Sin. As a result, the waveform of an output signal Sout will become discrete, undesirably and newly generating a high frequency noise component.

Namely, since a hold signal component Shld kept at a predetermined level during a noise mixing period $\tau$ is suddenly switched over to an input signal Sin at a time point t2 at which the noise mixing period $\tau$ has ended (hold is released), even if an external noise is removed, a waveform at a time point t2 of the output signal Sout will become discrete, newly generating a high frequency noise component. For this reason, when a processing such as a detection and a demodulation is carried out based on the output signal Sout, a distortion or the like will occur in a detection signal and a demodulation signal, rendering it difficult to improve a reception quality.

The present invention has been accomplished in view of the above-discussed problems and it is an object of the present invention to provide a noise canceller which does not newly generate a high frequency noise component when applying a hold processing to an input signal.

Means for Solving the Problem(s)

An invention recited in claim 1 is a noise canceller which removes a noise mixed in an input signal, comprising: noise period detecting means for detecting a noise mixing period of said noise mixed in said input signal; correction period setting means for setting a period including the noise mixing period and an additional period as a correction period; hold means for holding said input signal and outputting a hold signal during said correction period; first mute means for applying a mute processing to said input signal to generate a correction signal; second mute means for applying a mute processing to the hold signal to generate an interpolation signal; gain adjusting means for adjusting gains of the first mute means and the second mute means during at least the noise mixing period and the additional period of the correction period; and synthesizing means for synthesizing together the correction signal and the interpolation signal generated in the first mute means and the secondmute means and generating an output signal having a waveform similar to the waveform of the input signal not containing said noise.

An invention recited in claim 2 is based on an invention recited in claim 1, wherein the gain adjusting means sets the gain of the first mute means at a fixed value during periods other than said correction period, sets the gain of the first mute means at 0 during the noise mixing period of said correction period, and sets the gain of the first mute means at a value which changes from 0 to the fixed value during said additional period. Further, the gain adjusting means sets the gain of the second mute means at 0 during periods other than said correction period, sets the gain of the second mute means at a fixed value during the noise mixing period of said correction period, and sets the gain of the second mute means at a value which changes from the fixed value to 0 during said additional period.

Brief Description of the Drawings

Fig. 1 shows the composition and operation of a conventional noise canceller.
Fig. 2 is a block diagram showing the composition of a noise canceller formed according an embodiment of the present invention.
Fig. 3 is a timing chart showing an operation of the noise canceller of Fig. 2.
Fig. 4 provides block diagrams showing the composition of a noise canceller according to one embodiment.
Fig. 5 is a timing chart showing an operation of the noise canceller of Fig. 4.

Best Mode of Carrying Out the Invention

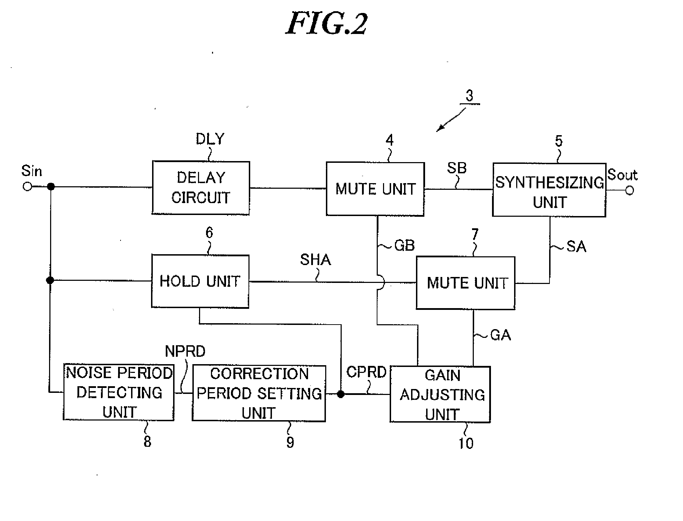

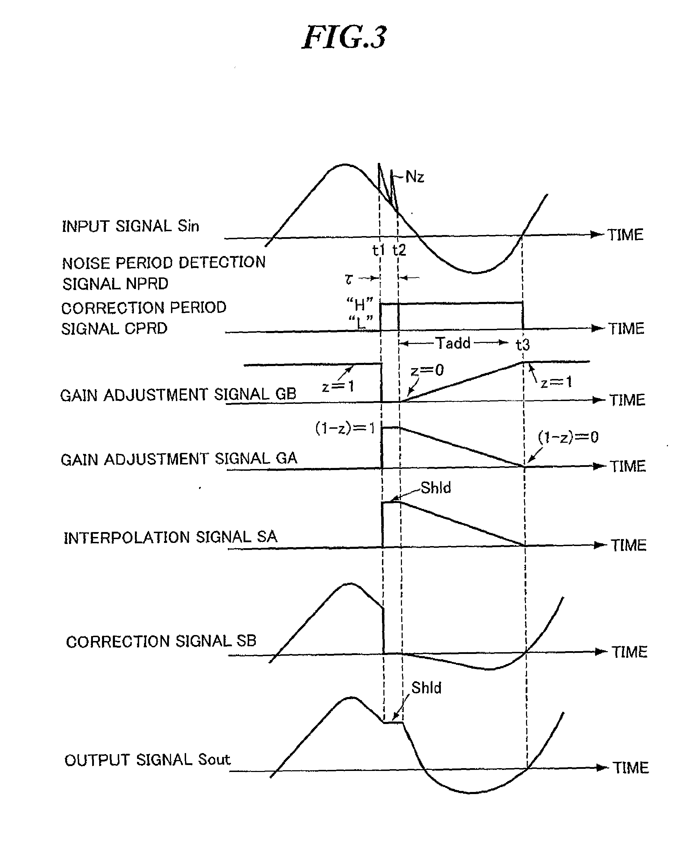

Next, description will be given to explain a preferred embodiment of the present invention with reference to Fig. 2 and Fig. 3. Fig. 2 is a block diagram showing the composition of a noise canceller formed according an embodiment of the present invention. Fig. 3 is a timing chart showing an operation of the noise canceller.

As shown in Fig. 2, the noise canceller 3 comprises a first mute unit 4, a synthesizing unit 5, a hold unit 6, a second mute unit 7, a noise period detecting unit 8, a correction period setting unit 9, and a gain adjusting unit 10, thereby making it possible to remove a noise mixed in an input signal Sin so as to output an output signal Sout. Further, the present embodiment involves a delay circuit DLY for performing a timing adjustment.

The noise period detecting unit 8 detects a noise mixed in the input signal Sin, and further detects a period $\tau$ during which a noise is occurring. Subsequently, the noise period detecting unit 8 outputs a noise period detection signal NPRD indicating a noise mixing period $\tau$.

The correction period setting unit 9 adds a predetermined additional time Tadd to a noise mixing period $\tau$ of the noise period detection signal NPRD so as to set a correction period ($\tau$+Tadd), thereby outputting an information indicating the correction period ($\tau$+Tadd) and a correction period signal CPRD.

The delay circuit DLY is a delay device for adjusting a delay time necessary in the operation of the noise canceller 3, mainly for adjusting a delay time caused due to an internal processing time between the noise period detecting unit 8 and the correction period setting unit 9.

The hold unit 6 holds an input signal for a correction period ($\tau$+Tadd) in accordance with a correction period signal CPRD and outputs the signal. Namely, the hold unit 6 passes an input signal Sin without processing during periods other than a correction period ($\tau$+Tadd), and holds the signal component of the input signal Sin at a start point of the correction period ($\tau$+Tadd), keeps the hold signal component having a constant level until the end of the correction period ($\tau$+Tadd) and then outputs the same. Afterwards, the signal to be outputted is supplied as a hold signal SHA to the mute unit 7.

The gain adjusting unit 10 outputs gain adjustment signals GA and GB for variably adjusting the gains of the mute units 4 and 7 during a period which is the correction period ($\tau$+Tadd) indicated by the correction period signal CPRD.

Namely, duringperiods other than a correction period ($\tau$+Tadd), the gain adjusting unit 10 will operate in accordance with the following equation (1), to set a gain value of a gain adjustment signal GB at a fixed value 1 and a gain value of a gain adjustment signal GA at 0. Further, during a noise mixing period $\tau$ of the correction period ($\tau$+Tadd), the gain adjusting unit 10 will operate in accordance with the following equation (2), to set the gain value of the gain adjustment signal GB at a fixed value 0 and the gain value of the gain adjustment signal GA at 1. Moreover, during an additional period Tadd of the correction period ($\tau$+Tadd), the gain value of the gain adjustment signal GB is variably adjusted with an increasing rate (1/Tadd) from 0 to 1 in accordance with a passed time t (namely, $0 \leq t \leq$ Tadd), while the gain value of the gain adjustment signal GA is variably adjusted with an increasing rate (1- (1/Tadd) from 1 to 0 in accordance with a passed time t (namely, $0 \leq t \leq$ Tadd).

Subsequently, the gain adjusting unit 10 adjusts the gain of the mute unit 7 in accordance with a gain value of the gain adjustment signal GA, and adjusts the gain of the mute unit 4 in accordance with a gain value of the gain adjustment signal GB.

[Equation 1]

$$GA = 0, GB = 1 \text{ (periods other than a correction period } (\tau + Tadd))$$

... (1)

[Equation 2]

$$GA = 1, GB = 0 \text{ (a noise mixing period } \tau) \quad ... \quad (2)$$

[Equation 3]

$$GB = 1(1/Tadd)t \quad \text{(an additional period Tadd)}$$

$$GA = 1-(1/Tadd)t \quad \text{(an additional period Tadd)} ... (3)$$

The mute unit 4 receives the input signal Sin and performs a mute processing in accordance with a gain value specified by the gain adjustment signal GB, thereby generating a correction signal SB and supplying the same to the synthesizing unit 5. Namely, as shown in the following equation (4), a mute processing is performed which is equivalent to a multiplication of the input signal Sin with a gain value of the gain adjustment signal GB shown in the above equations (1) - (3), thereby generating and outputting a correction signal SB.

[Equation 4]

$$SB = Sin \times GB \quad ... \quad (4)$$

The mute unit 7 receives the hold signal SHA and performs a mute processing in accordance with a gain value specified by the gain adjustment signal GA, thereby generating an interpolation signal SA and supplying the same to the synthesizing unit 5. Namely, as shown in the following equation (5), a mute processing is performed which is equivalent to a multiplication of the hold signal SHA with a gain value of the gain adjustment signal GA shown in the above equations (1) - (3), thereby generating and outputting the interpolation signal SA.

[Equation 5]

$$SA = SHA \times GA \quad \dots \quad (5)$$

The synthesizing unit 5 operates in accordance with the following equation (6) to synthesize together the correction signal SB and the interpolation signal SA (adding together the amplitudes thereof), thereby generating and outputting an output signal Sout formed by removing the noise from the input signal Sin.

[Equation 6]

$$Sout = SA + SB \quad \dots \quad (6)$$

Next, with reference to Fig. 3, description will be given to explain an operation of the noise canceller having the above-described constitution. However, for the sake of an easy description, the following description will be focused on an example in which an external noise Nz is being mixed in an input signal Sin within a period from a certain time point t1 to another time point t2, as shown in Fig. 3.

Namely, once the foregoing input signal Sin is inputted into the noise canceller 3, the noise period detecting unit 8 detects a noise mixing period $\tau$ which lasts from a time point t1 at which a noise Nz occurs to a time point t2 at which the noise disappears and outputs a noise period detection signal NPRD. Further, the correction period setting unit 9 adds an additional period Tadd to the noise mixing period $\tau$, thereby generating and outputting a correction period signal CPRD indicating a correction period ($\tau$+Tadd)

Furthermore, the hold unit 6 operates in accordance with an instruction specified by the correction period signal CPRD to hold the signal component of the input signal Sin at a start point t1 of the correction period ($\tau$+Tadd) (more strictly, a signal component immediately before the mixing of the noise Nz), and continue to output the hold signal SHA having a constant level.

Namely, during periods other than the correction period, the hold unit 6 passes an input signal Sin without processing to any extent. On the other hand, during a correction period, the hold unit 6 outputs a hold signal component Shld having a constant level as a hold signal SHA, instead of outputting a noise Nz mixed in the input signal Sin.

Further, the gain adjusting unit 10 adjusts the gains of the respective mute units 7 and 4 in accordance with the respective gain values of the gain adjustment signals GA and GB expressed by the foregoing equations (1) - (3).

In this way, according to a change in a gain value (in Fig. 3, gain value is represented by z) of the gain adjustment signal GB, the mute unit 4 applies a mute processing to the input signal Sin, thereby outputting a correction signal SB having a waveform shown in Fig. 3.

Namely, since the gain value (z) of the gain adjustment signal GBbecomes 1 during periods other than the correction period ($\tau$+Tadd), the mute unit 4 will output the input signal Sin as a correction signal SB without processing to any extent. Further, within the period $\tau$, since the gain value (z) of the gain adjustment signal GB becomes 0, the mute unit 4 will substantially forbid the passing of the input signal Sin, thereby outputting a correction signal SB having an amplitude of 0. Moreover, within an additional period Tadd, the mute unit 4 will apply a mute processing to the input signal Sin in response to a situation in which the gain value (z) of the gain adjustment signal GB changes from 0 towards 1, thereby outputting a correction signal SB having a waveform shown in Fig. 3.

On the other hand, the mute unit 7 will also apply a mute processing to the hold signal SHA according to a change in the gain value (In Fig. 3, gain value is represented by (1-z)) of the gain adjustment signal GA, thereby outputting an interpolation signal SA having a waveform shown in Fig. 3.

Namely, duringperiods other than a correction period ($\tau$+Tadd), since a gain value (1-z) of the gain adjustment signal GA becomes 0, the mute unit 7 will substantially forbid the passing of the hold signal SHA, thereby outputting an interpolation signal SAhaving an amplitude of 0. Further, within the period $\tau$, since the gain value (1-z) of the gain adjustment signal GA becomes 1, the mute unit 7 will allow the passing of the hold signal SHA (namely, the hold signal component Shld) having a constant level as an interpolation signal SA without processing to any extent. Moreover, within an additional period Tadd, the mute unit 7 will apply a mute processing to the hold signal SHA according to a situation in which a gain value (1-z) of the gain adjustment signal GA changes from 1 towards 0 (changing towards a time point t3 at which the additional period Tadd has ended), thereby outputting an interpolation signal SA having a waveform shown in Fig. 3.

Subsequently, the synthesizing unit 5 synthesizes together the correction signal SB and the interpolation signal SA, thereby outputting an output signal Sout having a waveform not containing any noise, as shown in Fig. 3.

Here, during periods other than a correction period (τ+Tadd), since the correction signal SB has the same waveform as the input signal Sin and since the interpolation signal SA has an amplitude of 0, the output signal Sout has the same waveform as the input signal Sin. Further, within a noise mixing period τ, the correction signal SB has an amplitude of 0, while the interpolation signal SA has a waveform in which a noise Nz has been replaced by a hold signal component Shld. As a result, the output signal Sout has the same waveform as the hold signal Shld having a constant level. Moreover, during an additional period Tadd, the correction signal SB has a waveform in which the input signal Sin has been attenuated by virtue of mute processing, while the interpolation signal SA has a waveform in which the hold signal SHA has been attenuated by virtue of mute processing. As a result, the output signal Sout has a wave form similar to the input signal Sin by synthesizing together the attenuated correction signal SB and interpolation signal SA.

Furthermore, since the amplitude of the output signal Sout at a time point at which an amount of time lasting from a noise mixing period τ to an additional period Tadd has passed, changes continuously at a smooth amplitude variation from a hold signal SHA having a constant level, there would be no high frequency noise component occurring.

As described above with reference to Fig. 1 (b) , a conventional noise canceller is such that at a time point t2 at which a hold action is terminated, the hold signal component Shldhaving a constant level will be broken instantly, and this will newly and internally generate a high frequency noise. In the noise canceller 3 of the present embodiment, a synthesized signal component formed by synthesizing together an interpolation signal SA and a correction signal SB to be mute-processed within an additional period Tadd and having not any sudden change, will continue after the hold signal component Shld having a constant level. As a result, there would be no high frequency noise occurring internally.

As descried above, according to the noise canceller 3 of the present embodiment, with respect to the hold signal SHA generated by replacing a noise Nz mixed in the input signal Sin with a hold signal component Shld, a mute processing is performed within an additional period Tadd so as to generate an interpolation signal SA, while the input signal Sin of the noise mixing period τ is processed to remove its signal component and its noise Nz, followed by a mute processing during an additional period Tadd so as to generate a correction signal SB, thus generating an output signal Sout by synthesizing together the interpolation signal SA and the correction signal SB. In this way, it is possible to remove the noise Nz mixed in the input signal Sin, as well as to prevent an internal generation of a high frequency noise component.

Further, the noise canceller 3 of the present embodiment may be provided in a vehicle radio receiver or the like, so as to remove an external noise (such as ignition noise or the like) mixed in an intermediate frequency signal (IF signal) outputted from the tuner unit of the broadcast receiver and supply the signal to the detector, or to remove a similar external noise mixed in a baseband signal detected in the detector and supply the signal to the demodulator, thus rendering it possible to reproduce a higher quality baseband signal and demodulation signal.

On the other hand, the noise canceller 3 of the present embodiment can be used not only in a broadcast receiver, but can also be broadly used to remove an external noise mixed in an input signal.

Example

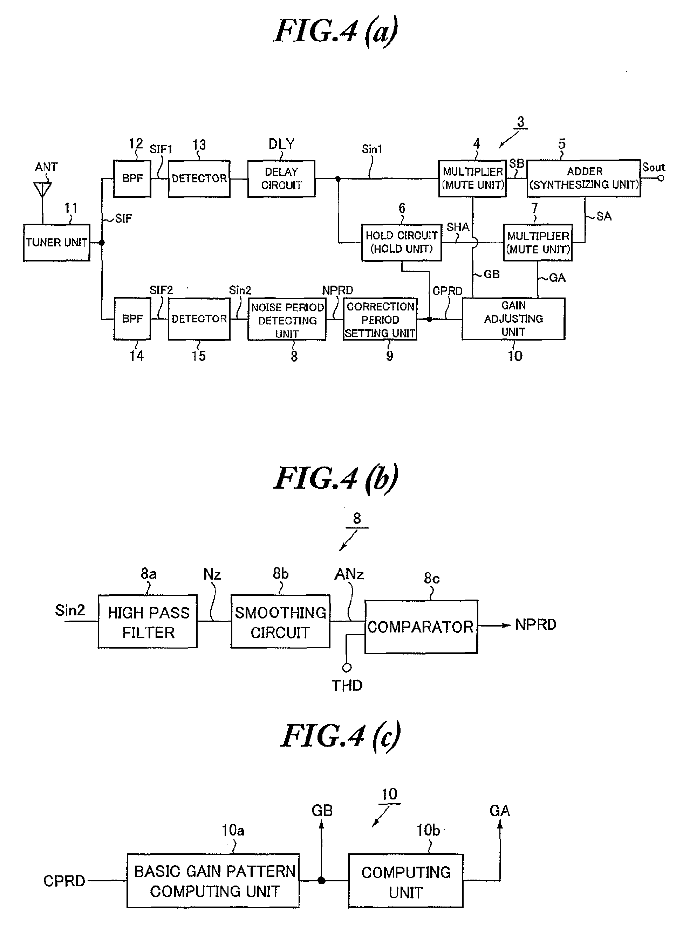

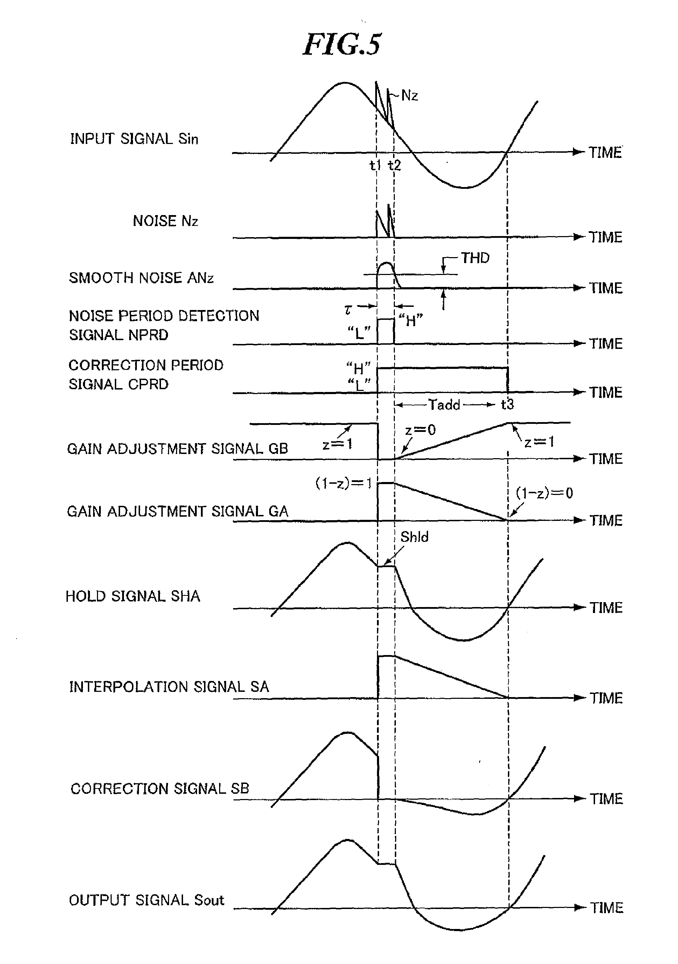

Next, with reference to Fig. 4 and Fig. 5, description will be given to explain an example of a noise canceller provided in a vehicle radio receiver for receiving radio broadcast. Fig. 4 is a block diagram showing the composition of the noise canceller of the present embodiment, while portions which are the same as or corresponding to those in Fig. 2 will be represented by the same reference numerals. Fig. 5 is a timing chart showing an operation of the noise canceller of the present embodiment.

As shown in Fig. 4, the noise canceller 3 of the present embodiment is connected in wiring system such that it can remove an external noise Nz such as ignition noise currently mixed in the baseband signal (AM detection signal) Sin1 detected within the receiver, and output a baseband signal Sout not containing the noise.

Namely, the tuner unit 11 of the receiver mixes a high frequency reception signal (RF reception signal) generated in the reception antenna ANT with a turning frequency local oscillation signal to perform a frequency conversion so as to generate an intermediate frequency signal (IF signal) SIF. Meanwhile, a first IF band pass filter 12 limits the frequency band of the intermediate frequency signal SIF and amplifies the same to an amplitude level capable of receiving a signal processing, thereby outputting a first intermediate frequency signal SIF1 for generating the baseband signal Sin1 as a desired signal component. Further, the detector 13 AM-detects the first intermediate frequency signal SIF1, thereby generating and thus outputting the first baseband signal Sin1.

Furthermore, a second IF band pass filter 14 which has a broader pass frequency band than the first IF band pass filter 12 limits the frequency band of the intermediate frequency signal SIF and amplifies the same to an amplitude level capable of receiving a signal processing, thereby outputting a second intermediate frequency signal SIF2. Meanwhile, the detector 15 AM-detects the second intermediate frequency signal SIF2, so that the noise canceller 3 of the present embodiment can generate and thus output a baseband signal Sin2 for detecting a noise.

1 Then, an output signal Sout of the below-mentioned adder 5 is outputted to a speaker system or the like, thereby providing a user or the like with an AM broadcast program.

Next, description will be given to explain in detail the constitution of the noise canceller 3 of the present embodiment. Namely, the noise canceller 3 has a multiplier 4 and a hold circuit 6 both connected to an output terminal of the detector 13 through a delay circuit DLY provided for adjusting a delay time. The noise canceller 3 further includes: a multiplier 7 subordinately connected to the hold circuit 6; an adder 5 for adding together two outputs of the multipliers 4 and 7 to output an output signal Sout; a noise period detecting unit 8 connected to the output terminal of the detector 15; a correction period setting unit 9 and a gain adjusting unit 10 successively and subordinately connected to the noise period detecting unit 8.

Here, the hold circuit 6, the multipliers 4 and 7, and the adder 5 are equivalent to the hold unit 6, the mute units 4, 7 and the synthesizing unit 5 shown in Fig. 2, with the noise period detecting unit 8, the correction period setting unit 9, and the gain adjusting unit 10 being the same to those shown in Fig. 2.

The noise period detecting unit 8 has a composition shown in Fig. 4 (b) . A high frequency noise Nz mixed in the second baseband signal Sin2 is passed through a high pass filter 8a so as to be extracted. A smoothing circuit 8b detects the envelop of the extracted noise Nz so as to generate a smooth noise component. Further, a comparator 8c compares the smooth noise component with a predetermined threshold value THD, thereby detecting as a noise mixing period $\tau$ a period during which the smooth noise component has a larger amplitude than the threshold value THD. Subsequently, the noise period detection signal NPRD indicating a detected noise mixing period $\tau$ is outputted to the correction period setting unit 9.

The correction period setting unit 9, upon receiving the noise period detection signal NPRD, supplies information on a noise mixing period $\tau$ and an additional period Tadd to the gain adjusting unit 10. During a period (correction period) including the noise mixing period $\tau$ and the additional period Tadd ($\tau$+Tadd), the correction period setting unit 9 will generate a correction period signal CPRD which is logic "H" and supply the same to the hold circuit 6 as well as to the gain adjusting unit 10.

As shown in Fig. 4 (c), the gain adjusting unit 10 includes: a basic gain pattern computing unit 10a for computing a changing pattern of a gain value (z) of a gain adjustment signal GA to be supplied to the multiplier 7; and a computing unit 10b for computing a changing pattern of a gain value (z) of a gain adjustment signal GB to be supplied to the multiplier 4 in accordance with the gain value z of the gain adjustment signal GA.

Namely, as described with reference to the foregoing equations (1) to (3), the basic gain pattern computing unit 10a operates in accordance with information on a noise mixing period $\tau$ and an additional period Tadd supplied from the correction period setting unit 9, to set the gain value (z) of the gain adjustment signal GB at 1 during periods other than the correction period ($\tau$+Tadd), set the gain value (z) of the gain adjustment signal GB at 0 during a noise mixing period $\tau$, and set the gain value (z) of the gain adjustment signal GB at a value changing from 0 to 1 at an increasing rate (1/Tadd).

The computing unit 10b operates in accordance with the gain value (z) of the gain adjustment signal GB generated by the basic gain pattern computing unit 10a, to perform a computation represented by (1-z) , thereby setting a gain value (1-z) of the gain adjustment signal GA.

Then, the gain adjusting unit 10 supplies the gain adjustment signal GA to the multiplier 7 and performs a multiplication of a hold signal SHA with a gain value (1-z) of the gain adjustment signal GA, so as to generate an interpolation signal SA. Further, the gain adjusting unit 10 supplies the gain adjustment signal GB to the multiplier 4 and performs a multiplication of a baseband signal Sin1 fed from the delay circuit DLY with a gain value (z) of the gain adjustment signal GB, thereby generating a correction signal SB.

The adder 5 adds together the interpolation signal SA and the correction signal SB, thereby synthesizing and thus outputting an output signal Sout having a waveform similar to the baseband signal Sin1 free from noise Nz.

Next, description will be given to explain an operation of the noise canceller 3 of the present embodiment having the above-described constitution, with reference to Fig. 5. However, for the sake of an easy explanation, the baseband signals Sin1 and Sin2 to be inputted will be both represented by an input signal Sin. Further, during a period from a certain time point t1 to another time point t2, the external noise Nz will be explained as a noise mixed in an input signal Sin (namely, baseband signals Sin1 and Sin2) .

Once the foregoing input signal Sin is inputted into the noise canceller 3, the high pass filter 8a provided in the noise period detecting unit 8 will pass a noise Nz currently mixed in a baseband signal Sin2, while the smoothing circuit 8b will smooth the noise component noise Nz so as to generate a smooth noise component ANz. Further, the comparator 8c will compare the threshold value THD with the smooth noise component ANz, thereby outputting a noise period detection signal NPRD which is logic "H" indicating a noise mixing period $\tau$.

Furthermore, the correction period setting unit 9 supplies information on a noise mixing period $\tau$ and an additional period Tadd to the gain adjusting unit 10, and at the same time generates and thus outputs a correction period signal CPRD indicating a correction period ($\tau$+Tadd).

In addition, the hold circuit 6 operates in accordance with an instruction specified by the correction period signal CPRD, to hold a signal component of an input signal Sin at a start point t1 of the correction period, and continue to output a hold signal component Shld having a constant level as a hold signal SHA until an end point t3 of the correction

period ($\tau$+Tadd).

Moreover, the basic gain pattern computing unit 10a and the computing unit 10b within the gain adjusting unit 10 will set the gain value (1-z) of the gain adjustment signal GA, and the gain value (z) of the gain adjustment signal GB, and will perform a mute processing within a period in which the correction period signal CPRD has become logic "H". Namely, a mute processing is performed until a time point t3 at which the correction period signal CPRD reverses from logic "H" to logic "L."

In this way, the multiplier 4 operates in accordance with a change in the gain value (z) of the gain adjustment signal GB, to apply a mute processing to the baseband signal Sin1 and output a correction signal SB having a waveform shown in the graph.

Namely, duringperiods other than a correction period ($\tau$+Tadd), since the gain value (z) of the gain adjustment signal GB becomes 1, the multiplier 4 will output a baseband signal Sin1 as a correction signal SB without any processing. Further, within a noise mixing period $\tau$, since the gain value (z) of the gain adjustment signal GB becomes 0, the multiplier 4 will substantially stop the passing of the baseband signal Sin1, thereby outputting a correction signal SB having an amplitude of 0. Moreover, within an additional period Tadd, the multiplier 4 will apply a mute processing to the baseband signal Sin1, in accordance with a change of the gain value (z) of the gain adjustment signal GB from 0 to 1, thereby outputting a correction signal SB having a waveform shown in the graph.

On the other hand, the multiplier 7 will similarly apply a mute processing to a hold signal SHA in accordance with a change of the gain value (1-z) of the gain adjustment signal GA, thereby outputting a correction signal SB having a waveform shown in the graph.

Namely, duringperiods other than a correction period ($\tau$+Tadd), since the gain value (z-1) of the gain adjustment signal GA becomes 0, the multiplier 7 will substantially stop the passing of a hold signal SHA, thereby outputting a correction signal SA having an amplitude of 0. Further, within a noise mixing period $\tau$, since the gain value (z-1) of the gain adjustment signal GA becomes 1, the multiplier 7 will pass the hold signal component Shld of a hold signal SHA as an interpolation signal SA without any processing. Moreover, within an additional period Tadd, the multiplier 7 will apply a mute processing to the hold signal SHA, in accordance with a change of the gain value (z-1) of the gain adjustment signal GA from 1 to 0, thereby outputting a correction signal SA having a waveform shown in the graph.

Then, the adder 5 adds together the correction signal SB and the interpolation signal SA so as to generate and thus output an output signal Sout having a waveform free from any noise, as shown in the graph.

Here, during periods other than a correction period ($\tau$+Tadd), since the correction signal SB has the same waveform as the baseband signal Sin1 and the interpolation signal SA has an amplitude of 0, the output signal Sout will have the same waveform as the baseband signal Sin1. Further, during a noise mixing period $\tau$, since the correction signal SB has an amplitude of 0 and the interpolation signal SA has a waveform in which the noise Zn has been replaced by a hold signal component Shld, the output signal Sout will have the same waveform as the hold signal component Shld having a constant level. Moreover, during an additional period Tadd, the correction signal SB has a waveform in which the baseband signal Sin1 has been attenuated by a mute processing, the interpolation signal SA has a waveform in which a hold signal SHA has been attenuated by a mute processing. As a result, the output signal Sout will have a waveform similar to the baseband signal Sin1 by adding together the attenuated correction signal SB and interpolation signal SA.

Further, since the amplitude of an output signal Sout at a time point at which a time has passed from a noise mixing period $\tau$ to an additional period Tadd will continuously change at a smooth amplitude changing curve from a hold signal component Shld having a constant level, there would be no high frequency noise component occurring.

Namely, in the noise canceller 3 of the present embodiment, following the hold signal component Shld is a synthesized signal component which is generated by synthesizing together the correction signal SB and the interpolation signal SA to be mute-processed within the additional period Tadd and which will not have a sudden change. As a result, there would be no high frequency noise occurring internally.

As described above, according to the noise canceller 3 of the present embodiment, within an additional period Tadd a mute processing is applied to a hold signal SHA generated by using a hold signal component Shld to replace a noise Nz mixed in the AM-detected baseband signal Sin1, while the baseband signal Sin1 of the noise mixing period $\tau$ is processed to remove its signal component and noise Nz, followed by performing a mute processing within an additional period Tadd, thereby generating the correction signal SB and adding together the interpolation signal SA and the correction signal SB, thus generating an output signal Sout. In this way, it is possible to remove the noise Nz mixed in the baseband signal Sin1 and to prevent an internal occurrence of a high frequency noise component.

Although the above description has been given to explain an embodiment of a noise canceller provided in an AM broadcast receiver, the noise canceller of the present embodiment can also be used in an FMbroadcast receiver. Further, the noise canceller of the present invention is applicable not only to an analog broadcast receiver, but also to a digital broadcast receiver capable of receiving a digital broadcast such as terrestrial digital broadcast or the like. Namely, the noise canceller 3 of the present embodiment can be formed into a digital circuit to receive as an input signal a baseband signal detected by a detector of a digital broadcast receiver or a demodulation signal demodulated by a demodulator to perform a digital signal processing. In this way, it is possible to remove a noise mixed in an input signal, without newly and internally causing an occurrence of a high frequency noise component.

**Claims**

1. A noise canceller for removing a noise mixed in an input signal, comprising:

noise period detecting means for detecting a noise mixing period of said noise mixed in said input signal;
correction period setting means for setting a period including the noise mixing period and an additional period as a correction period;
hold means for holding said input signal and outputting a hold signal during said correction period;
first mute means for applying a mute processing to said input signal to generate a correction signal;
second mute means for applying a mute processing to the hold signal to generate an interpolation signal;
gain adjusting means for adjusting gains of the first mute means and the second mute means during at least the noise mixing period and the additional period of the correction period; and
synthesizing means for synthesizing together the correction signal and the interpolation signal generated in the first mute means and the second mute means and generating an output signal having a waveform similar to the waveform of the input signal not containing said noise.

2. The noise canceller according to claim 1,
wherein the gain adjusting means sets the gain of the first mute means at a fixed value during periods other than said correction period, sets the gain of the first mute means at 0 during the noise mixing period of said correction period, and sets the gain of the first mute means at a value which changes from 0 to the fixed value during said additional period,
wherein the gain adjusting means sets the gain of the second mute means at 0 during periods other than said correction period, sets the gain of the second mute means at a fixed value during the noise mixing period of said correction period, and sets the gain of the second mute means at a value which changes from the fixed value to 0 during said additional period.

3. The noise canceller according to claim 2, wherein the gain adjusting means sets the fixed value at 1.

4. A noise removal method to be carried out by a noise canceller for removing a noise mixed in an input signal, said method comprising:

a noise period detecting step for detecting a noise mixing period of said noise mixed in said input signal;
a correction period setting step for setting a period including the noise mixing period and an additional period as a correction period;
a hold step for holding said input signal and outputting a hold signal during said correction period;
a first mute step for applying a mute processing to said input signal to generate a correction signal;
a second mute step for applying a mute processing to the hold signal to generate an interpolation signal;
a gain adjusting step for adjusting gains of the first mute means and the second mute means during at least the noise mixing period and the additional period of the correction period; and a synthesizing step for synthesizing together the correction signal and the interpolation signal generated in the first mute means and the second mute means and generating an output signal having a waveform similar to the waveform of the input signal not containing said noise.

## *FIG.1 (a)*

## *FIG.1 (b)*

*PRIOR ART*

## FIG.2

# FIG.3

INPUT SIGNAL Sin

NOISE PERIOD DETECTION
SIGNAL NPRD

CORRECTION PERIOD
SIGNAL CPRD

GAIN ADJUSTMENT SIGNAL GB

GAIN ADJUSTMENT SIGNAL GA

INTERPOLATION SIGNAL SA

CORRECTION SIGNAL SB

OUTPUT SIGNAL Sout

# FIG.4 (a)

```
                                              3
         12  SIF1   13        DLY              Sin1      4              5
 ANT    ┌─────┐  ┌────────┐  ┌────────┐              ┌──────────┐ SB ┌──────────────┐ Sout
  ▽     │ BPF │  │DETECTOR│  │ DELAY  │        ●─────│MULTIPLIER│────│    ADDER     │──○
        └─────┘  └────────┘  │CIRCUIT │              │(MUTE UNIT)│   │(SYNTHESIZING │
    11    │SIF               └────────┘              └──────────┘    │    UNIT)     │
 ┌──────┐ │                                 6                        └──────────────┘
 │TUNER │ │                           ┌──────────┐ SHA   7               │ SA
 │ UNIT │●│                    ●──────│  HOLD    │────┌──────────┐        │
 └──────┘ │                           │ CIRCUIT  │    │MULTIPLIER│        │
          │                           │(HOLD UNIT)│   │(MUTE UNIT)│       │
          │                           └──────────┘    └──────────┘        │
          │                                │      ~GB        │ ~GA         │
          │  SIF2      Sin2       NPRD     │    CPRD         │             │
        ┌─────┐  ┌────────┐  ┌──────────┐┌──────────┐  ┌────────────┐
        │ BPF │  │DETECTOR│  │  NOISE   ││CORRECTION│  │    GAIN    │
        └─────┘  └────────┘  │  PERIOD  ││  PERIOD  │●─│ ADJUSTING  │
                             │ DETECTING││ SETTING  │  │   UNIT     │
                             │   UNIT   ││   UNIT   │  └────────────┘
                             └──────────┘└──────────┘
          14        15           8           9              10
```

# FIG.4 (b)

```
                            8
                            /

         8a      Nz    8b      ANz     8c
 Sin2  ┌─────────┐  ┌──────────┐    ┌────────────┐
 ────│ HIGH PASS │──│SMOOTHING │────│ COMPARATOR │───▶ NPRD
       │  FILTER  │  │ CIRCUIT  │    │            │
       └─────────┘  └──────────┘    └────────────┘
                                        │
                                        ○
                                       THD
```

# FIG.4 (c)

```
                        10
                        /
              10a    GB         10b      GA
       ┌──────────────────┐   ↑   ┌──────────┐  ↑
 CPRD──│  BASIC GAIN PATTERN│──●──│COMPUTING │──
       │  COMPUTING UNIT    │     │   UNIT   │
       └──────────────────┘      └──────────┘
```

13

# FIG.5

INPUT SIGNAL Sin — TIME

NOISE Nz — TIME

SMOOTH NOISE ANz — TIME

NOISE PERIOD DETECTION SIGNAL NPRD — TIME

CORRECTION PERIOD SIGNAL CPRD — TIME

GAIN ADJUSTMENT SIGNAL GB — TIME

GAIN ADJUSTMENT SIGNAL GA — TIME

HOLD SIGNAL SHA — TIME

INTERPOLATION SIGNAL SA — TIME

CORRECTION SIGNAL SB — TIME

OUTPUT SIGNAL Sout — TIME

## INTERNATIONAL SEARCH REPORT

<table>
<tr><td colspan="2">International application No.<br>PCT/JP2006/305028</td></tr>
</table>

A. CLASSIFICATION OF SUBJECT MATTER
**_H04B1/10_**(2006.01)

According to International Patent Classification (IPC) or to both national classification and IPC

B. FIELDS SEARCHED

Minimum documentation searched (classification system followed by classification symbols)
H04B1/10

Documentation searched other than minimum documentation to the extent that such documents are included in the fields searched

| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-056173 A (Mitsubishi Electric Corp.), 19 February, 2004 (19.02.04), Full text; Figs. 1 to 15 (Family: none) | 1-4 |
| A | JP 2004-187074 A (Pioneer Electronic Corp.), 02 July, 2004 (02.07.04), Full text; Figs. 1 to 7 & EP 1427111 A2 & US 2004/0108906 A1 | 1-4 |
| A | JP 2003-069435 A (Pioneer Electronic Corp.), 07 March, 2003 (07.03.03), Full text; Figs. 1 to 7 & EP 1286472 A2 & US 2003/0039327 A1 | 1-4 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>27 April, 2006 (27.04.06) | Date of mailing of the international search report<br>16 May, 2006 (16.05.06) |
|---|---|
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/305028

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-069389 A  (Pioneer Electronic Corp.),<br>07 March, 2003 (07.03.03),<br>Full text; Figs. 1 to 7<br>& EP 1286472 A2        & US 2003/0039327 A1 | 1-4 |
| A | JP 57-176511 A  (Hitachi, Ltd.),<br>29 October, 1982 (29.10.82),<br>Full text; Figs. 1 to 7<br>& EP 0044687 A1        & US 4843488 A | 1-4 |
| A | JP 61-030183 A  (Sanyo Electric Co., Ltd.),<br>12 February, 1986 (12.02.86),<br>Full text; Figs. 1 to 6<br>(Family: none) | 1-4 |

Form PCT/ISA/210 (continuation of second sheet) (April 2005)